# EUROPEAN PATENT APPLICATION

(11) **EP 4 521 450 A1**
(43) Date of publication of application: **12.03.2025**
(21) Application number: 24196695.1
(22) Date of filing: 27.08.2024
(51) Int. Cl.: H01L 21/67, H01L 21/687

(54) **THERMAL SWITCH FOR WAFER TEMPERATURE MODULATION**

(30) Priority: 31.08.2023 US 202363536044 P
(71) Applicant: ASM IP Holding B.V., 1322 AP Almere (NL)
(72) Inventor: ZHANG, Hang, 1322 AP Almere (NL)
(74) Representative: V.O.

(57) **Abstract**

A method, system and apparatus for substrate processing that includes a susceptor, a thermal protection plate disposed above the susceptor, the thermal protection plate includes a first lift pin through-hole extending from a top surface of the thermal protection plate to a bottom surface of the thermal protection plate, the susceptor includes a second lift pin through-hole and a plate lift member through-hole, and a plate lift member configured to slidably engage the plate lift member through-hole.

## Description

### FIELD OF INVENTION

The present disclosure relates generally to a semiconductor processing apparatus and particularly a semiconductor processing apparatus comprising a mechanism for preventing contamination of a substrate supported by a susceptor. The disclosure also generally relates to methods for processing a substrate and particularly methods for preventing contamination of a substrate during a processing phase.

### BACKGROUND

Reaction chambers may be used for depositing various material layers onto semiconductor substrates. A semiconductor substrate, such as, for example, a silicon substrate, may be placed on a susceptor inside a reaction chamber. Both the substrate and the susceptor may be heated to a desired substrate temperature set point. In an example substrate treatment process, one or more reactant gases may be passed over a heated substrate, causing the deposition of a thin film of material on the substrate surface. Throughout subsequent deposition, doping, lithography, etch, and other processes, these layers are made into integrated circuits.

One important controlled condition during processing is temperature of the substrate. With ever-advancing technology nodes, the demand to quickly modulate the substrate temperature is likewise increasing. Currently, temperature modulation is challenging due to the difficulty associated with quickly changing the temperature of a large volume of materials within the chamber that can radiate heat to the substrate thwarting efforts to change the substrate temperature quickly.

### BRIEF SUMMARY

This summary is provided to introduce a selection of concepts in a simplified form. These concepts are described in further detail in the detailed description of example embodiments of the disclosure below. This summary is not intended to necessarily identify key features or essential features of the claimed subject matter, nor is it intended to be used to limit the scope of the claimed subject matter.

In one aspect, a substrate processing assembly, includes a susceptor, a thermal protection plate disposed above the susceptor, the thermal protection plate includes a first lift pin through-hole extending from a top surface of the thermal protection plate to a bottom surface of the thermal protection plate, the susceptor includes a second lift pin through-hole and a plate lift member through-hole, and a plate lift member configured to slidably engage the plate lift member through-hole.

The apparatus may also include where the thermal protection plate has a surface and includes polished silicon carbide, polished diamond-like carbon coating, a layer of aluminum nitride or a layer of diamond-like carbon, or combinations thereof.

The apparatus may also include where the thermal protection plate further includes a plate lift member coupling feature on the bottom surface.

The apparatus may also include where the thermal protection plate includes a feature that extends from the bottom surface and conforms to a shape of a mating cavity in the susceptor top surface.

The apparatus may also include where the susceptor includes a feature that extends from the top surface and conforms to a shape of a mating cavity in the thermal protection plate.

The apparatus may also include where the thermal protection plate mounting surface is concave to constrain lateral movement.

The apparatus may also include where the plate lift member is coupled to an actuator.

The apparatus may also include a plurality of coupling features disposed on the bottom surface of the thermal protection plate, where one or more of the plurality of coupling features is configured to couple to one or more of the plurality of plate lift members.

The apparatus may also include where one or more of the plate lift member through-holes is axially aligned with at least one of the plurality of coupling features.

The apparatus may also include where the first lift pin through-hole of the thermal protection plate is axially aligned with the second lift pin through-hole of the susceptor.

The apparatus may also include where the thermal protection plate further includes a mounting surface includes a recess configured to provide circumferential support to a substrate disposed in the recess.

The apparatus may also include where the plate lift member includes a coupling feature at a tip.

The apparatus may also include where the coupling feature of the plate lift member includes at least one of a roughed surface, an adhesive surface, or a fastener, or a combination thereof.

The apparatus may also include where the thermal protection plate mounting surface includes a top mounting surface including a sloped side wall to constrain lateral movement. Other technical features may be readily apparent to one skilled in the art from the following figures, descriptions, and claims.

In one aspect, a semiconductor processing method includes the steps of placing a substrate on a surface of a thermal protection plate over a susceptor within a chamber, contacting the susceptor with the thermal protection plate, exposing the substrate to a first process heating substrate to a first temperature, moving the thermal protection plate to a position breaking contact with the susceptor, and cooling the substrate responsive to the breaking contact.

The method may also include where the first temperature is between about 200° C. and about 600° C.

The method may also include exposing the substrate to a second process, heating substrate to a second temperature where the second temperature is lower than the first temperature. Other technical features may be readily apparent to one skilled in the art from the following figures, descriptions, and claims.

The apparatus may also include where the plate lift member coupling feature includes a recess, a mating surface, a roughed surface, an adhesive surface, or a fastener, or a combination thereof.

The method may also include where the first temperature is between about 200° C. and about 600° C.

The method may also include where the second temperature is between about 10° C. and about 200° C. Other technical features may be readily apparent to one skilled in the art from the following figures, descriptions, and claims.

For the purpose of summarizing the disclosure and the advantages achieved over the prior art, certain objects and advantages of the disclosure have been described herein above. Of course, it is to be understood that not necessarily all such objects or advantages can be achieved in accordance with any particular embodiment or example of the disclosure. Thus, for example, those skilled in the art will recognize that the examples disclosed herein can be carried out in a manner that achieves or optimizes one advantage or group of advantages as taught or suggested herein without necessarily achieving other objects or advantages as can be taught or suggested herein.

All of these examples are intended to be within the scope of the disclosure. These and other embodiments will become readily apparent to those skilled in the art from the following detailed description of certain examples having reference to the attached figures, the disclosure not being limited to any particular example(s) discussed.

### BRIEF DESCRIPTION OF THE SEVERAL VIEWS OF THE

### DRAWINGS

While the specification concludes with claims particularly pointing out and distinctly claiming what are regarded as embodiments or examples of the disclosure, the advantages of examples of the disclosure may be more readily ascertained from the description of certain examples of the disclosure when read in conjunction with the accompanying drawings. Elements with the like element numbering throughout the figures are intended to be the same.
FIG. 1 illustrates a schematic diagram of a reactor system, in accordance with an example of the present technology.
FIG. 2 illustrates a schematic diagram of a reactor system having multiple reaction chambers, in accordance with an example of the present technology.
FIG. 3A illustrates a schematic diagram of a reactor system, in accordance with an example of the present technology.
FIG. 3B illustrates a schematic diagram of a reactor system, in accordance with an example of the present technology.
FIG. 3C illustrates a schematic diagram of a reactor system, in accordance with an example of the present technology.
FIG. 3D illustrates a schematic diagram of a reactor system, in accordance with an example of the present technology.
FIG. 4 illustrates a schematic diagram of a component of reactor system, in accordance with an example of the present technology.
FIG. 5 illustrates a schematic diagram of a component of reactor system, in accordance with an example of the present technology.
FIG. 6 illustrates a schematic diagram of a component of reactor system, in accordance with an example of the present technology.
FIG. 7 illustrates a schematic diagram of a component of reactor system, in accordance with an example of the present technology.
FIG. 8 illustrates a schematic diagram of a component of reactor system, in accordance with an example of the present technology.
FIG. 9 illustrates a schematic diagram of a component of reactor system, in accordance with an example of the present technology.
FIG. 10 illustrates a schematic diagram of a component of reactor system, in accordance with an example of the present technology.
FIG. 11 illustrates a processing method, in accordance with an example of the present technology.

### DETAILED DESCRIPTION

The detailed description of various examples herein makes reference to the accompanying drawings, which show the exemplary examples by way of illustration. While these exemplary examples are described in sufficient detail to enable those skilled in the art to practice the disclosure, it should be understood that other examples may be realized and that logical, chemical, and/or mechanical changes may be made without departing from the spirit and scope of the disclosure. Thus, the detailed description herein is presented for purposes of illustration only and not of limitation. For example, the steps recited in any of the method or process descriptions can be executed in any combination and/or order and are not limited to the combination and/or order presented. Further, one or more steps from one of the disclosed methods or processes can be combined with one or more steps from another of the disclosed methods or processes in any suitable combination and/or order. Moreover, any of the functions or steps can be outsourced to or performed by one or more third parties. Furthermore, any reference to singular includes plural examples, and any reference to more than one component can include a singular example.

Although certain embodiments and examples are disclosed below, it will be understood by those in the art that the disclosure extends beyond the specifically disclosed examples and/or uses of the disclosure and obvious modifications and equivalents thereof. Thus, it is intended that the scope of the disclosure should not be limited by the particular examples described herein.

The illustrations presented herein are not meant to be actual views of any particular material, apparatus, structure, or device, but are merely representations that are used to describe examples of the disclosure.

As used herein, the term "substrate" can refer to any underlying material or materials that may be used, or upon which, a device, a circuit, or a film/layer may be formed.

As used herein, the term "atomic layer deposition" (ALD) can refer to a vapor deposition process in which deposition cycles, preferably a plurality of consecutive deposition cycles, are conducted in a process chamber. Typically, during each cycle the precursor is chemisorbed to a deposition surface (e.g., a substrate surface or a previously deposited underlying surface such as material from a previous ALD cycle), forming a monolayer or sub-monolayer that does not readily react with additional precursor (i.e., a self-limiting reaction). Thereafter, if necessary, a reactant (e.g., another precursor or reaction gas) can subsequently be introduced into the process chamber for use in converting the chemisorbed precursor to the desired material on the deposition surface. Typically, this reactant is capable of further reaction with the precursor. Further, purging steps can also be utilized during each cycle to remove excess precursor from the process chamber and/or remove excess reactant and/or reaction byproducts from the process chamber after conversion of the chemisorbed precursor. Further, the term "atomic layer deposition," as used herein, is also meant to include processes designated by related terms such as, "chemical vapor atomic layer deposition", "atomic layer epitaxy" (ALE), molecular beam epitaxy (MBE), gas source MBE, or organometallic MBE, and chemical beam epitaxy when performed with alternating pulses of precursor composition(s), reactive gas, and purge (e.g., inert carrier) gas.

As used herein, the term "chemical vapor deposition" (CVD) can refer to any process wherein a substrate is exposed to one or more volatile precursors, which react and/or decompose on a substrate surface to produce a desired deposition.

As used herein, the terms "layer," "film," and/or "thin film" can refer to any continuous or non-continuous structures and material deposited by the methods disclosed herein. For example, "layer," "film," and/or "thin film" could include 2D materials, nanorods, nanotubes, or nanoparticles or even partial or full molecular layers or partial or full atomic layers or clusters of atoms and/or molecules. "Layer," "film," and/or "thin film" can comprise material or a layer with pinholes, but still be at least partially continuous.

Further, in this disclosure, any two numbers of a variable can constitute a workable range of the variable, and any ranges indicated can include or exclude the endpoints. Additionally, any values of variables indicated (regardless of whether they are indicated with "about" or not) can refer to precise values or approximate values and include equivalents, and can refer to average, median, representative, majority, or the like. Further, in this disclosure, the terms "including," "constituted by" and "having" can refer independently to "typically or broadly comprising," "comprising," "consisting essentially of," or "consisting of" in some examples. In this disclosure, any defined meanings do not necessarily exclude ordinary and customary meanings in some examples.

The examples of the disclosure may include semiconductor processing apparatus and methods that may be utilized for processing a substrate within a semiconductor processing apparatus. The semiconductor processing apparatus may comprise a dual chamber module, wherein an upper chamber is configured for processing one or more substrates, and a lower chamber is configured for the loading and unloading of one or more substrates into and out of the semiconductor processing apparatus.

The transfer of a substrate between the lower chamber and the upper chamber may be achieved through the use of lift pins. For example, a susceptor, upon which the substrate may be disposed during processing, may include a plurality of through-holes. Each through-hole may have an associated lift pin which can traverse in the vertical plane between the lower chamber and the upper chamber. For example, in some embodiments, the semiconductor processing apparatus may comprise a susceptor including three through-holes with a corresponding three lift pins which may move in unison up and down in the vertical plane to raise and lower a substrate between the lower chamber and the upper chamber.

In an example, inefficiencies of the conventional technology discussed above may be mitigated by provision of a thermal protection plate of with low emissivity and high thermal conductivity inserted between the susceptor and the substrate within a processing chamber. The substrate may sit on the thermal protection plate. To cool down the substrate the thermal protection plate may be raised, due to the low emissivity the thermal protection plate acts as a radiation shield and substrate will absorb low radiation from the heater side. To heat up the substrate return the thermal protection plate in contact with heater, the thermal protection plate may quickly absorb heat due to the thermal protection plate's high thermal conductivity, it acts as an excellent heat spreader.

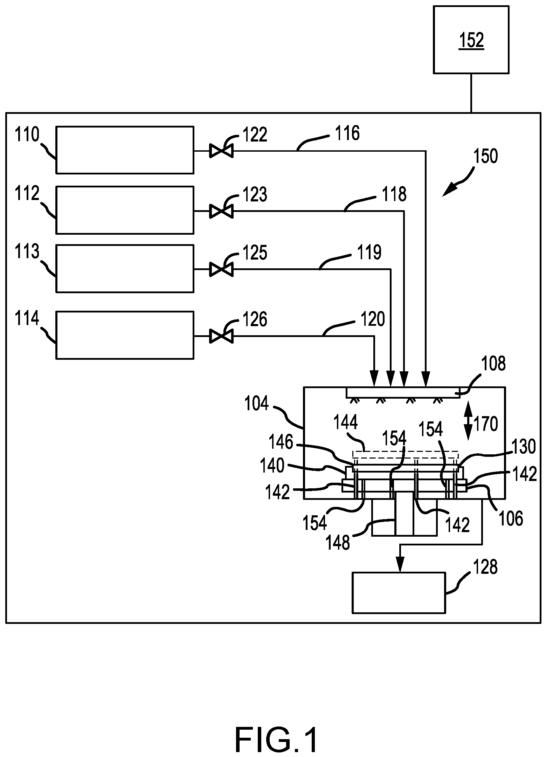

Referring now to FIG. 1, in various examples, a reactor system 150 can comprise a reaction chamber 104, a susceptor 106, and a thermal protection plate 140 to hold a substrate 130 during processing.

In an example, a plurality of lift pins 142 may be disposed beneath substrate 130 and slidably engaged within through-holes in susceptor 106 and thermal protection plate 140. Lift pins 142 may be configured to translate vertically in the direction of arrows 170 and to contact and lift substrate 130 off of thermal protection plate 140 (e.g., to a first substrate position 144). Lift pins 142 may be further configured to lower substrate 130 from first substrate position 144 to rest on thermal protection plate 140 (e.g., in a second substrate position 146).

In an example, one or a plurality of plate lift members 154 may be disposed beneath thermal protection plate 140 and slidably engaged within respective plate lift member through-holes 318 in susceptor 106. Plate lift members 154 may be configured to translate vertically in the direction of arrows 170 and to contact and lift thermal protection plate 140 off of susceptor 106 (e.g., to a first substrate position). Plate lift members 154 may be further configured to lower thermal protection plate 140 to rest on susceptor 106.

In an example, susceptor 106 may be coupled to an actuator 148 configured to translate in the vertical direction so as to raise and lower susceptor 106, thermal protection plate 140 and substrate 130 within chamber 104 during processing (e.g., to contact reactants).

In an example, reactor system 150 may include a fluid distribution system 108 (e.g., a showerhead) to distribute one or more reactants to a surface of substrate 130, one or more reactant sources 110, 112, and/or 113, and/or a carrier and/or purge gas source 114, fluidly coupled to reaction chamber 104 via respective lines 116, 118, 119 and 120, and respective valves or controllers 122, 123, 125 and 126. Reactant gases or other materials from respective sources 110, 112, and/or 113 can be applied to substrate 130 in reaction chamber 104. Purge gas from gas source 114 can be flowed to and through reaction chamber 104 to remove any excess reactant or other undesired materials from reaction chamber 104. System 150 can also comprise a vacuum source 128 fluidly coupled to the reaction chamber 104, which can be configured to evacuate reactants, a purge gas, or other materials out of reaction chamber 104.

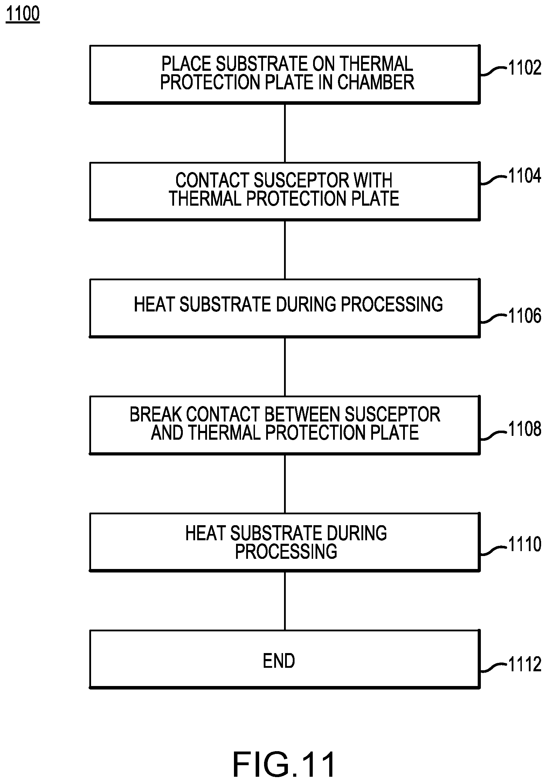

Controller 152 can be configured to perform various functions and/or steps as described herein. Controller 152 can include one or more microprocessors, memory elements, and/or switching elements to perform the various functions. Although illustrated as a single unit, controller 152 can alternatively comprise multiple devices. By way of example, controller 152 can be used to control gas flow (e.g., by monitoring flow rates and controlling valves 122, 123, 125 and/or 126), movement (e.g., vertical translation in the direction of arrows 170) of lift pins 142, plate pins 154, actuator 148, various motors, heaters, cooling devices and/or vacuum source 128 to execute various processes (e.g., method 1100 shown in FIG 11). Further, when a system includes two or more reaction chambers, as described in more detail below, the two or more reaction chambers can be coupled to the same/shared controller.

In some examples, a reactor system (e.g., reactor system 150) can comprise multiple reaction chambers.

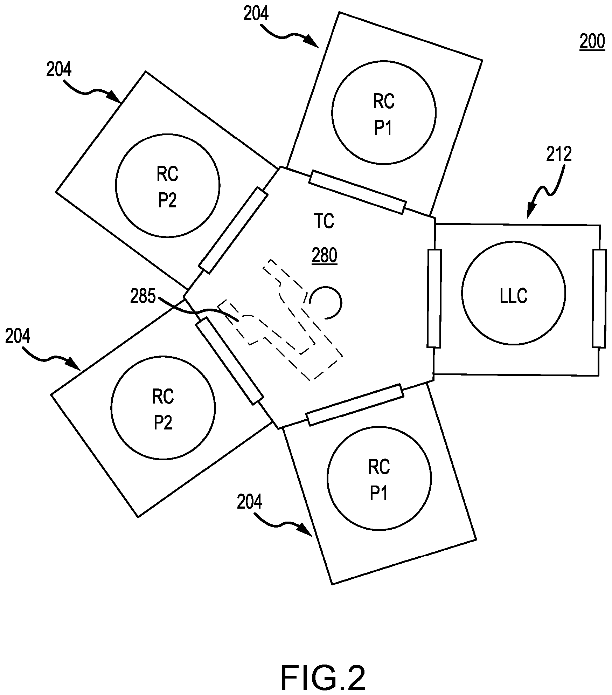

Referring now to FIG. 2, for example, in reactor system 200, a number of reaction chambers 204 (each of which can be an example of reaction chamber 104 in FIG 1) can be disposed around and/or coupled to a transfer chamber 280 comprising a transfer tool 285 for transferring substrates between reaction chambers 204. Substrates can be transferred from a load lock chamber 212 and between reaction chambers 204 (e.g., through transfer chamber 280). For example, a substrate 130 can be disposed in different chambers for different steps of a semiconductor manufacturing process (e.g., etching, oxidizing, passivation and/or deposition steps may each be performed in the same or different chambers).

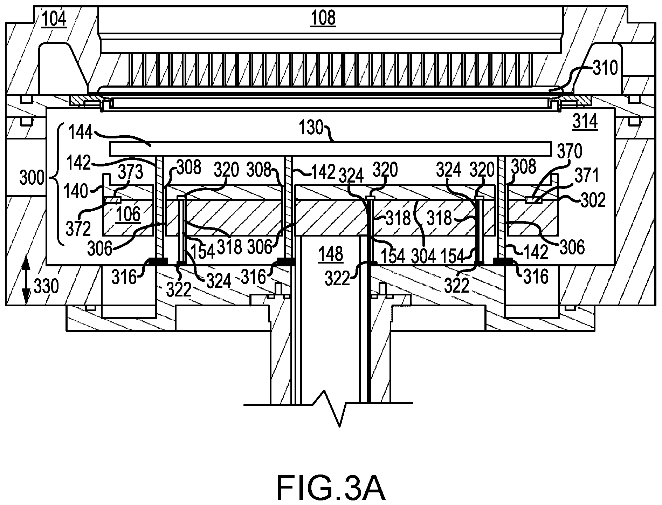

FIG. 3A-3D are schematic drawings illustrating various positions of a susceptor 106, thermal protection plate 140 and substrate 130 assembly 300 within reaction chamber 104.

FIG. 3A is a schematic drawing illustrating a cutaway view of an example reaction chamber 104 comprising lower chamber 314 and upper chamber 310. Susceptor 106 is disposed in lower chamber 314 in a lowered position and substrate 130 is disposed in a raised first substrate position 144 held up by lift pins 142. Substrate 130 and susceptor 106 may be in these positions for loading/unloading substrate 130 and/or for other purposes.

In an example, a bottom surface 304 of thermal protection plate 140 may be supported on a thermal protection plate mounting surface 302 of susceptor 106.

In an example, one or more lift pins 142 may be disposed beneath substrate 130 and slidably engaged within respective lift pin through-holes 306 in susceptor 106 and respective lift pin through-holes 308 in thermal protection plate 140. In an example, one or more lift pin through-holes 306 in susceptor 106 and lift pin through-holes 308 in thermal protection plate 140 may be axially aligned so as to slidably engage a lift pin through both a lift pin through-holes 308 and a lift pin through-holes 306. In an example, one or more lift pins 142 may be configured to mate to and/or be seated in or on respective bases 316.

In an example, plate lift members 154 may be configured to translate in the vertical plane and to lift thermal protection plate 140 off susceptor 106. Plate lift members 154 may be further configured to lower thermal protection plate 140 to rest on susceptor 106.

Plate lift members 154 may each be slidably engaged within respective plate lift member through-holes 318 extending through susceptor 106. Plate lift members 154 may be fabricated of any of a variety of materials such as metal (e.g., stainless steel, aluminum, C22) or ceramic (e.g., SiOx, AlN, AlOx, SiC, SiN), or any other appropriate material. Plate lift members 154 may be of any of a variety of shapes or dimensions selected to permit plate lift members 154 to pass through, through-holes 308.

In an example, plate lift members 154 may be configured to translate up and down in the vertical direction in the direction of arrows 170. Translation of plate lift members 154 in the vertical plane may be actuated by any of a variety of methods. For example, plate lift members 154 may be coupled to respective lift mechanisms 322 configured to raise and lower plate lift members 154.

In an example, a plate lift member 154 may comprise a shaft 324 that can be translated vertically in the direction of arrows 330. It will be understood that the vertical translation can be accomplished, for example, by various mechanisms such as a motor, a pneumatic actuator, a screw driven actuator, a stepper motor, or any appropriate conventional lift mechanism 322. It will be further understood by one of skill in the art that plate lift members 154 having such a shaft 324 can be elevated or may comprise a telescoping portion that can raise and lower thermal protection plate 140 and/or substrate 130.

In an example, plate lift members 154 may be configured to contact a bottom surface 304 of thermal protection plate 140. In an example, bottom surface 304 may have one or more coupling features 320 configured to couple to respective plate lift members 154. Coupling features 320 may assist in adhering or otherwise connecting plate lift members 154 to bottom surface 304 of thermal protection plate 140. One or more coupling features 320 may comprise a notch, a trench, a recess, a fastener, a roughened surface, a textured surface, a high friction material contact, an adhesive (e.g., Geckskin^{™}), or the like, or a combination thereof. In an example, coupling features 320 may comprise, and are not limited to, complementary mating features configured to mate thermal protection plate 140 to plate lift members 154.

In a further example, thermal protection plate 140 includes a feature 370 that extends from the bottom surface 304 and conforms to the shape of a mating cavity 371 or recess in top surface 302 susceptor 106.

In a further example, susceptor 106 includes a feature 372 that extends from the top surface 302 and conforms to the shape of a mating cavity 373 or recess in the thermal protection plate 140.

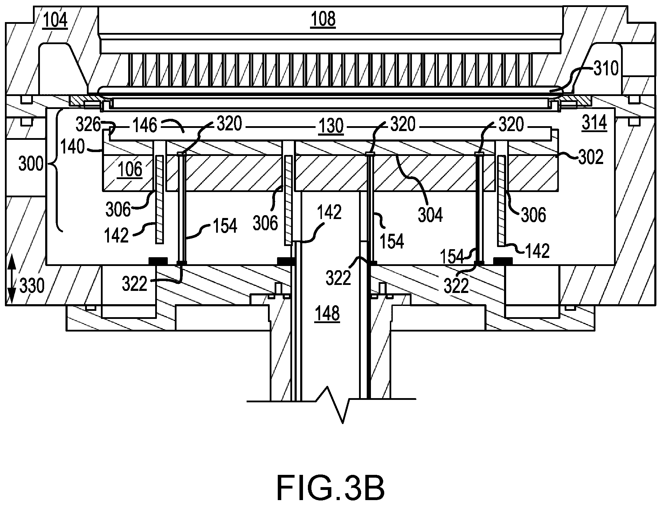

FIG. 3B is a schematic drawing illustrating a cutaway view of an example reaction chamber 104 comprising upper chamber 310 and lower chamber 314. In an example, susceptor 106, thermal protection plate 140, and substrate 130 are disposed in lower chamber 314. In an example, actuator 148 may raise susceptor 106 vertically in the direction of arrows 330. As depicted in FIG. 3B, susceptor 106 is near upper chamber 310. In an example, substrate 130 may be lowered to second substrate position 146 wherein substrate 130 is disposed within recess 326 of thermal protection plate 140. Substrate 130 and susceptor 106 may be in these positions for a variety of reasons such as, for example, transition to upper chamber 310 for substrate 130 processing, to cool or heat substrate 130, holding substrate 130 prior to unloading and/or storing substrate 130 and/or for other purposes.

In an example, substrate 130 may be lowered or positioned in recess 326 of thermal protection plate 140 as actuator 148 lifts susceptor 106 because lift pins 142 may retract into susceptor through-holes 306. Lift pins 142 may be held in susceptor 106 lift pin through-holes 306 while susceptor 106 is in a raised position.

In an example, thermal protection plate lift members 154 may be raised by respective lift mechanisms 322 and may stay coupled to or in contact with respective coupling feature 320 of thermal protection plate 140 whether or not thermal protection plate lift members 154 are applying force to thermal protection plate 140.

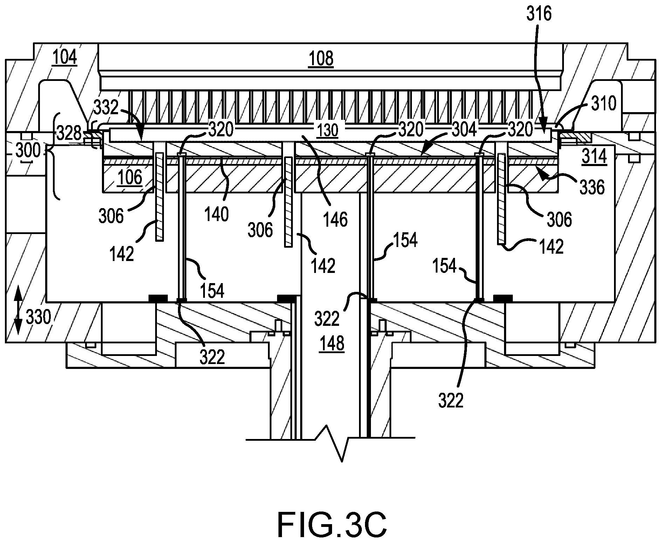

FIG. 3C is a schematic drawing illustrating a cutaway view of an example reaction chamber 104 comprising upper chamber 310 and lower chamber 314. In an example, assembly 300 is disposed such that substrate 130 is positioned in upper chamber 310 for processing.

In an example, substrate 130 is positioned on thermal protection plate mounting surface 332. When susceptor 130 is moved upwards in the direction of arrows 330, substrate 130 may be located in a processing region 328 with fluid distribution system 108 defining an upper surface of the processing region 328.

As depicted in FIG. 3C, susceptor 106 is at or near upper chamber 310. In an example, actuator 148 may raise susceptor 106 vertically in order to position substrate 130 within processing region 328. In an example, substrate 130 is still in second substrate position 146 wherein substrate 130 is disposed within recess 316 of thermal protection plate 140.

In an example, susceptor 106 may be configured to heat substrate 130 to a desired processing temperature and may comprise one or more heating devices 336 for this purpose. Susceptors are generally configured to heat a substrate 130 to a temperature within a specific range. The design configurations of the susceptor generally depend on the operating temperatures of a reactor chamber 104. By way of example, some susceptors can be configured to operate in a temperature range of about 200° C. to about 600° C., and other susceptors can be configured to operate in a range of about 10° C. to about 200° C. In some cases, it may be desirable to expose substrate 130 within a reactor to two or more different processes that run at substantially different temperatures. In such a case, susceptor 106 is likely not ideal to use at one or more different process temperatures. For example, high temperature (e.g., greater than about 200° C.) processes often use a high mass, high watt density susceptor to allow heating of the susceptor and the substrate. In contrast, lower temperature processes (e.g., less than about 200° C.) generally employ high mass, lower watt density susceptors, but in both cases the mass of the heater is high due to desirably maintaining a constant temperature setting.

In addition, if the susceptor is used for processes running at substantially different temperatures, it can take an undesirably long time to heat and/or cool the susceptor from one process temperature to another. To overcome this conventional drawback, thermal protection plate 140 may be separated from susceptor 106 to enable more rapid cooling of substrate 130 during processing and/or at other advantageous times.

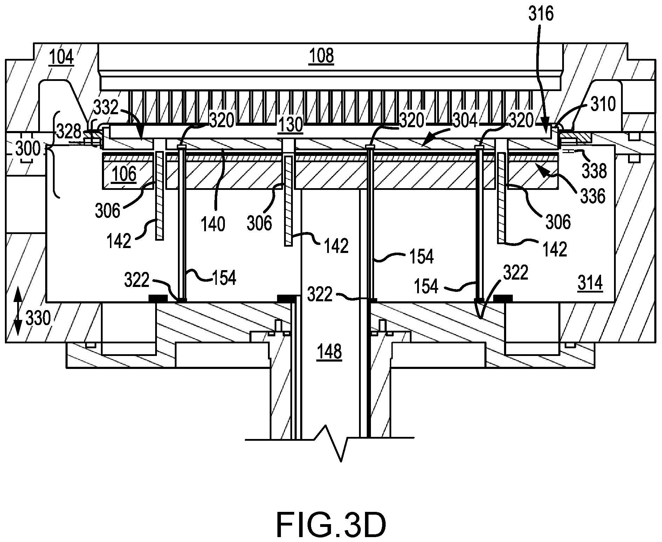

FIG. 3D is a schematic drawing illustrating a cutaway view of an example reaction chamber 104 comprising upper chamber 310 and lower chamber 314. In an example, assembly 300 is disposed such that substrate 130 is positioned in upper chamber 310 for processing.

In an example, susceptor 106 and/or other components in chamber 104 may heat substrate 130 during processing. It may be desirable to rapidly cool substrate 130 during processing (e.g., between processing steps having different processing temperatures). To enable cooling of substrate 130, thermal protection plate 140 may be separated from susceptor 106 during processing and/or at other advantageous times.

In an example, plate lift members 154 may be triggered to translate vertically to lift thermal protection plate 140 upward off susceptor 106.

In an example, thermal protection plate 140 may comprise a low emissivity material. Thus, even a small distance 338 (e.g., about 2.0 mm -15.0 mm) separation between the thermal protection plate 140 and susceptor 106 can inhibit radiative heat transfer from the susceptor 106 to the substrate 130 thus improving a cooling rate for substrate 130. Because the thermal protective plate 140 is highly thermally conductive, when the thermal protective plate 140 is in contact with the susceptor 106 it does not substantially interfere with heat transfer from susceptor 106 to substrate 130. Thus, coupling thermally protective plate 140 to susceptor 106 and removing thermally protective plate 140 from susceptor 106 can act as a switch to quickly change the temperature of the substrate 130.

Thermal protection plate 140 may comprise high thermal conductivity and low emissivity material to improve the thermal conduction while shielding substrate 130 from radiation.

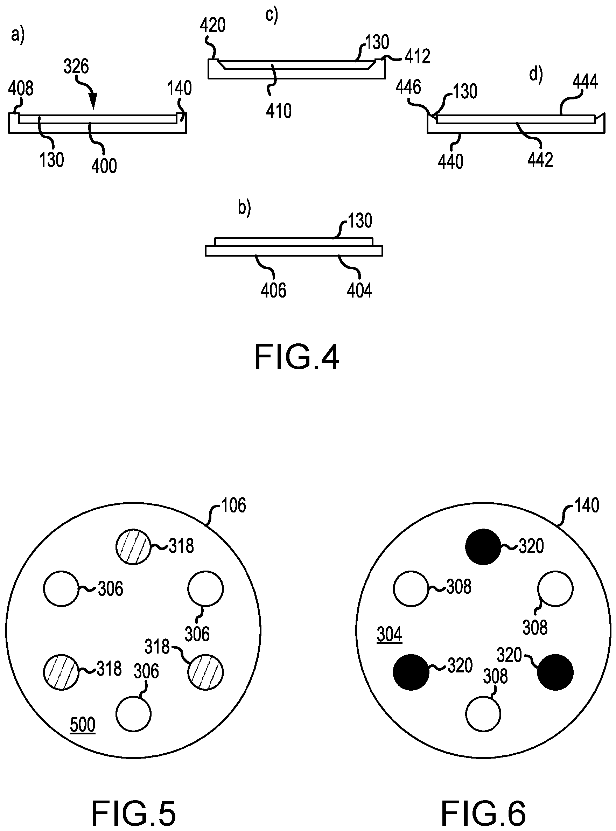

In an example, substrate 103 may be position within recess 326 and may contact a portion of thermal protection plate mounting surface (see FIG. 4). Such contact by substrate 130 with a high thermal conductivity material may further improve cooling of substrate 130 through dissipation of heat from substrate 130 to thermal protection plate 140.

FIG. 4 illustrates example variations of thermal protection plates in cross sectional view. In an example, in panel a), thermal protection plate 140 may comprise a substrate mounting surface 400 that is substantially flat and a recess 326 within which substrate 130 may be disposed. Recess 326 wall 408 may constrain lateral movement of substrate 130 by providing circumferential support about a perimeter of substrate 130 disposed in the recess 326.

In an example, in panel b), thermal protection plate 404 may comprise a substrate mounting surface 406 that is substantially flat without a recess 326 within which substrate 130 may be disposed. Such a configuration may rely on a vacuum or pressure differential with the chamber to prevent lateral displacement of substrate 130 on thermal protection plate 404.

In an example, in panel c), thermal protection plate 420 may comprise a substrate mounting surface 410 that is curved or concave within which substrate 130 may be disposed. Wall 412 may constrain lateral movement of substrate 130 by providing circumferential support about a perimeter of substrate 130.

In an example, in panel d), thermal protection plate 440 may comprise a substrate mounting surface 442 that is substantially flat and a recess 444 within which substrate 130 may be disposed. Recess 444 wall 446 may comprise a sloped edge such as a bevel, an angle, and/or a chamfered edge, or the like. Wall 446 may constrain lateral movement of substrate 130 by providing circumferential support about a perimeter of substrate 130 disposed in the recess 444. Other thermal protection plate shapes, surfaces, recesses and walls are possible and claimed subject matter is not limited in this regard.

FIG. 5 illustrates an example of a susceptor 106 in plan view. In an example, susceptor 106 may comprise one or more through-holes to accommodate one or more lift pins 142. Lift pin through-holes 306 are distributed about surface 500.

In an example, susceptor 106 may comprise one or more plate lift member through-holes 318 to accommodate plate lift members 154.

FIG. 6 illustrates an example of a thermal protection plate 140 in plan view. In an example, thermal protection plate 140 may comprise one or more through-holes to accommodate one or more lift pins. Lift pin through-holes 308 are distributed about bottom surface 304.

In an example, plate lift members 154 (see FIG. 1) may be configured to contact a bottom surface 304 of thermal protection plate 140. In an example, bottom surface 304 may have one or more coupling features 320 configured to couple to respective plate lift members 154. Coupling features 320 may assist in adhering or otherwise connecting plate lift members 154 to bottom surface 304 of thermal protection plate 140.

In an example, one or more of coupling features 320 may be axially aligned with plate lift member through-holes 318 in susceptor 106.

In some examples, a thermal protection plate 140 may comprise material having high thermal conductivity and/or low emissivity to improve cooling by thermal conduction while shielding a substrate (e.g., substrate 130) from radiation (radiative heat).

In an example, thermal protection plate 140 may comprise a silicon carbide plate wherein one or more surfaces of thermal protection plate 140 are a polished silicon carbide surface. For example, at least bottom surface 304 may have a polished silicon carbide surface. In other examples, additional surfaces of thermal protection plate 140 may comprise a polished silicon carbide surface. Such material may have thermal conductivity of about >120 W/(m.K) and emissivity of about 0.2 - 0.6.

In another example, thermal protection plate 140 may comprise a polished aluminum plate wherein one or more surfaces of thermal protection plate 140 are polished aluminum. For example, at least bottom surface 304 may be polished aluminum. Such materials can have thermal conductivity of about >240 W/(m.K) and emissivity of about 0.09 - 0.24. It should be recognized that thermal conductivity and emissivity of the polished surfaces depend on surface finish, oxidation and temperature, material composition and treatment. Other types of polished surfaces are known to those of skill in the art and may be used in accordance with the current disclosure and claimed subject matter is not limited in this regard.

In an example, a thin coating layer with high thermal conductivity and low emissivity on thermal protection plate 140 on bottom surface 304 may be used to further improve thermal protection plate 140's performance.

In an example, AlN (aluminum nitride) may be used to coat bottom surface 304 of thermal protection plate 140. AlN coatings exhibit low emissivity and typically fall within a range of about 0.2 to 0.6 and have thermal conductivity in a range of about 60- 320 W/(m.K).

In an example, DLC (diamond like coating) may be used to coat bottom surface 304 of thermal protection plate 140. DLC exhibit low emissivity and typically fall within a range of about 0.1 to 0.3, and have thermal conductivity in a range of about 400-1000 W/(m.K). Other types of coatings are known to those of skill in the art and may be used in accordance with the current disclosure and claimed subject matter is not limited in this regard.

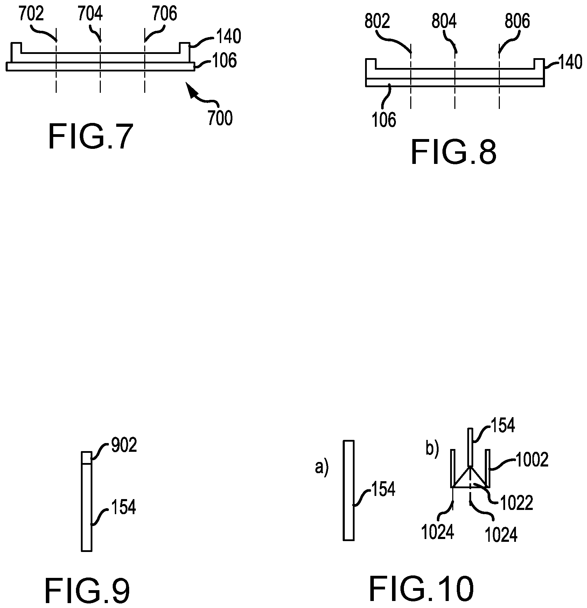

FIG. 7 illustrates an example of an assembly 700 comprising susceptor 106 and thermal protection plate 140. In an example, one or more lift pin through-holes 306 may be aligned with one or more of lift pin through-holes 308. One or more of lift pin through-holes 306 may be axially aligned with corresponding one or more of lift pin through-holes 308 along one or more axes 702, 704 and/or 706.

FIG. 8 illustrates an example of an assembly 800 comprising susceptor 106 and thermal protection plate 140. In an example, one or more plate lift member through-holes 318 may be aligned with one or more of coupling features 320. One or more of plate lift member through-holes 318 may be axially aligned with corresponding one or more of coupling features 320 along one or more axes 802, 804 and/or 806.

FIG. 9 illustrates an example of a plate lift member 154 having a coupling feature 902 at a tip of the plate lift member 154. In an example, plate lift members 154 may be configured to contact a bottom surface 304 of thermal protection plate 140. In an example, plate lift member 154 may have one or more coupling features 902 configured to couple to respective coupling features 320 which may assist in adhering or otherwise connecting plate lift members 154 to bottom surface 304 of thermal protection plate 140. One or more coupling features 902 may comprise a mating shape, a groove, a recess, a fastener, a roughened surface, a textured surface, a high friction material contact, an adhesive (e.g., Geckskin^{™}), or the like, or a combination thereof. In an example, coupling features 902 may comprise, and are not limited to, complementary mating features configured to mate thermal protection plate 140 to plate lift members 154.

FIG. 10 illustrates examples of various lift mechanisms. At panel a) is plate lift member 154 as described above with respect to FIGS 1-9. In another example, at panel b) lift actuator 1002 may comprise one or more plate lift members 154 coupled to a plate 1012. Plate 1012 may be any shape, for example, circular or triangular. Plate 1012 may be coupled to a motor and shaft 1024 (optionally disposed centrally on plate 1012 or to one side) which can be translated vertically in the direction of arrows 330 (see FIG. 3A). Plate 1012 may be hollow and may fit around lift pins so as to not interfere with the function of lift pins 142. Plate 1012 may be solid.

FIG. 11, is a flowchart illustrating a method 1100 for cooling a substate 130 (see FIG. 3A). Method 1100 includes the steps of placing a substrate 130 on a surface of a thermal protection plate 140 over susceptor 106 within a chamber 104 (step 1102), contacting susceptor 106 with thermal protection plate 140 (step 1104), exposing the substrate 130 to a first process heating substrate 130 to a first temperature (step 1106), moving the thermal protection plate 140 to a position breaking contact with susceptor 106 (step 1108). Breaking contact allows substrate 130 to cool to a temperature lower than the first temperature. Cooling results from the protection from radiative heat provided by thermal protection plate 140. Method 1100 proceeds to exposing the substrate 130 to a second process, heating substrate 130 to a second temperature (step 1110) wherein the second temperature is lower than the first temperature.

In accordance with exemplary aspects of these embodiments, the first process and the second process can be run at different temperatures. For example, the first process can be run at a temperature of about 200° C. to about 600° C.; the second process can be run at, for example, 10° C. to about 200° C. Additionally or alternatively, the substrate can be exposed to different reactants or inert gases during the first and second processes. And, the gas flow patterns can be varied, as described above, for the first and second processes. One or more of these changes can be made to distinguish the first process from the second process. The first and second processes can be the same (e.g., deposition) or different (e.g., clean, deposition) types of processes.

Although exemplary examples of the present disclosure are set forth herein, it should be appreciated that the disclosure is not so limited. Various modifications, variations, and enhancements of the system and method set forth herein may be made without departing from the spirit and scope of the present disclosure.

The subject matter of the present disclosure includes all novel and nonobvious combinations and subcombinations of the various systems, components, and configurations, and other features, functions, acts, and/or properties disclosed herein, as well as any and all equivalents thereof.

## Claims

1. A substrate processing assembly, comprising:
a susceptor (106);
a thermal protection plate (140) disposed above the susceptor (106), the thermal protection plate (140) comprising a first lift pin through-hole (308) extending from a top surface of the thermal protection plate (140) to a bottom surface of the thermal protection plate (140);
the susceptor (106) comprising a second lift pin through-hole (306) and a plate lift member through-hole (318); and
a plate lift member (154) configured to slidably engage the plate lift member through-hole (318).

2. The substrate processing assembly of claim 1, wherein the thermal protection plate (140) has a surface comprising polished silicon carbide, polished diamond-like carbon coating, a layer of aluminum nitride or a layer of diamond-like carbon, or combinations thereof.

3. The substrate processing assembly of claim 1 or 2, wherein the thermal protection plate (140) further comprises a plate lift member coupling feature (320) on the bottom surface (304).

4. The substrate processing assembly of claim 3, wherein the plate lift member coupling feature (320) comprises a recess, a mating surface, a roughed surface, an adhesive surface, or a fastener, or a combination thereof.

5. The substrate processing assembly according to any one of claims 1-4, wherein the thermal protection plate (140) includes a feature (370) that extends from the bottom surface (304) and conforms to a shape of a mating cavity (371) in a susceptor top surface (106).

6. The substrate processing assembly according to any one of claims 1-5, wherein the susceptor (106) includes a feature (372) that extends from the top surface (302) and conforms to a shape of a mating cavity (373) in the thermal protection plate (140).

7. The substrate processing assembly according to any one of claims 1-6, wherein the thermal protection plate mounting surface (410) is concave to constrain lateral movement.

8. The substrate processing assembly according to any one of claims 1-7, wherein the plate lift member (154) is coupled to an actuator (322; 1002).

9. The substrate processing assembly according to any one of claims 1-8, further comprising a plurality of coupling features (320) disposed on the bottom surface (304) of the thermal protection plate (140), wherein one or more of the plurality of coupling features (320) is configured to couple to one or more of the plurality of plate lift members (154).

10. The substrate processing assembly of claim 9, wherein one or more of the plate lift member through-holes (318) is axially aligned with at least one of the plurality of coupling features (320).

11. The substrate processing assembly according to any one of claims 1-10, wherein the first lift pin through-hole (308) of the thermal protection plate (140) is axially aligned with the second lift pin through-hole (306) of the susceptor (106).

12. The substrate processing assembly according to any one of claims 1-11, wherein the thermal protection plate (140) further comprises a mounting surface (400) comprising a recess (326) configured to provide circumferential support to a substrate (130) disposed in the recess (326).

13. The substrate processing assembly according to any one of claims 1-12, wherein the plate lift member (154) comprises a coupling feature (902) at a tip.

14. The substrate processing assembly of claim 13, wherein the coupling feature (902) of the plate lift member (154) comprises at least one of a roughed surface, an adhesive surface, or a fastener, or a combination thereof.

15. The substrate processing assembly according to any one of claims 1-14, wherein the thermal protection plate mounting surface (410) comprises a top mounting surface including a sloped side wall to constrain lateral movement.

16. A semiconductor processing method, comprising:
placing a substrate (130) on a surface of a thermal protection plate (140) over a susceptor (106) within a chamber (104);
contacting the susceptor (106) with the thermal protection plate (140);
exposing the substrate (130) to a first process heating substrate (130) to a first temperature;
moving the thermal protection plate (140) to a position breaking contact with the susceptor (106); and
cooling the substrate (130) responsive to the breaking contact.

17. The method of claim 16, wherein the first temperature is between about 200° C. and about 600° C.

18. The method of claim 16 or 17, further comprising exposing the substrate (130) to a second process, heating substrate (130) to a second temperature wherein the second temperature is lower than the first temperature.

19. The method of claim 18, wherein the first temperature is between about 200° C and about 600° C.

20. The method of claim 19, wherein the second temperature is between about 10° C and about 200° C.
